# EUROPEAN PATENT SPECIFICATION

(11) **EP 3 057 383 B1**
(45) Date of publication and mention of the grant of the patent: **04.04.2018**
(21) Application number: 13896770.8
(22) Date of filing: 30.10.2013
(51) Int. Cl.: H05K 1/02, H05K 3/00

(54) **SIGNAL CONNECTION APPARATUS**
SIGNALVERBINDUNGSVORRICHTUNG
APPAREIL DE CONNEXION DE SIGNAL

(43) Date of publication of application: 17.08.2016
(73) Proprietor: Huawei Technologies Co., Ltd., Longgang District Shenzhen, Guangdong 518129 (CN)
(72) Inventor: ZHANG, Lvquan, Shenzhen Guangdong 518129 (CN); LUO, Zonglang, Shenzhen Guangdong 518129 (CN); HE, Guodong, Shenzhen Guangdong 518129 (CN); PENG, Jin, Shenzhen Guangdong 518129 (CN)
(74) Representative: Pfenning, Meinig & Partner mbB
(86) International application number: PCT/CN2013/086228
(87) International publication number: WO 2015/061986

(56) References cited:
- CN-A- 102 354 887
- CN-A- 103 138 128
- CN-U- 201 813 608
- DE-A1-102007 036 939
- FR-A1- 2 698 755
- US-A1- 2003 099 098
- US-A1- 2011 075 384
- US-A1- 2011 157 844

## Description

### TECHNICAL FIELD

The present invention relates to wireless communications technologies, and in particular, to a signal connection apparatus.

### BACKGROUND

At present, in a wireless communications base station system, with the improvement of integration of a radio frequency module, a radio frequency blind mate connector (for example, an MBX connector) is widely used to transmit radio frequency signals between radio frequency modules. The radio frequency connector costs relatively high, and therefore is greatly limited to be widely used in products.

To avoid the foregoing cost problem, an interconnection technology with low costs merges in recent years, and according to this technology, a screw is used as an inner conductor to fasten a PCB (printed circuit board, printed circuit board) and a radio frequency module and transmit a signal between the PCB and the radio frequency module. With consideration of an assembly tolerance of a project, it is required to design a groove around a joint between the PCB and the screw and hollow a corresponding structure component below (a cantilever beam structure) to absorb tolerances in up and down directions. However, this design affects a ground effect of the joint, and impact on a ground electrical property becomes more apparent with an increase of a frequency. For example, when a product with a frequency above 2.6 G is applied, a loss of a radio frequency signal and a port reflection index drastically deteriorate and totally cannot meet an index requirement of a base station system.

In present invention, by using an interconnection apparatus for improving a radio frequency ground effect, a working frequency of a radio frequency signal connection apparatus can be increased substantially, and the interconnection apparatus can meet a system design requirement of a product with a working frequency above 2.6 G.

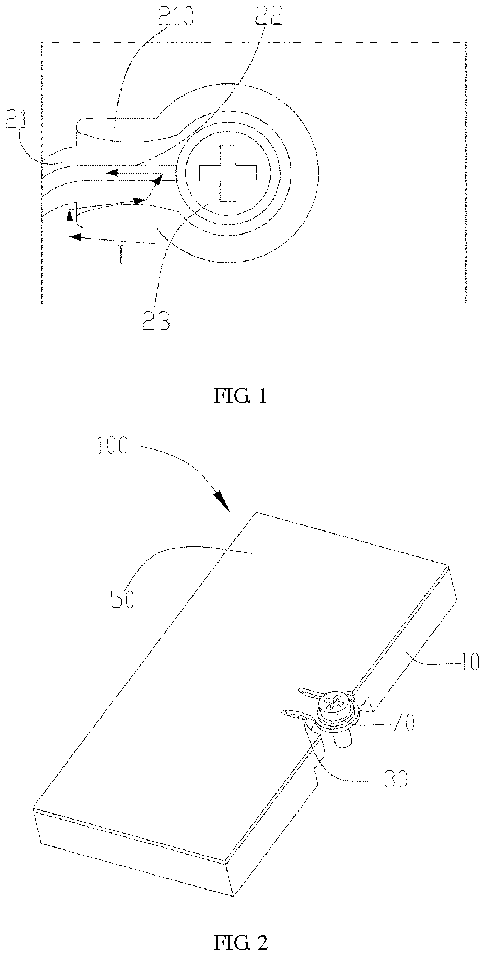

A separate test for such a radio frequency module using a hard link technology requires a PCB circuit board, and connection is made in a connection manner shown in FIG. 1.

As shown in FIG. 1, a PCB circuit board 21 is opened with a through groove 210, a structure, extending and protruding from the through groove 210, of the PCB circuit board 21 is a PCB cantilever beam structure 22 (the through groove 210 surrounds the PCB cantilever beam structure 22), and an end portion of the PCB cantilever beam structure 22 is disposed with a screw 23. With consideration of a problem that an assembly tolerance leads to bending of the PCB cantilever beam structure 22, a general method is to decrease a reacting force to the PCB circuit board 21 by lengthening the PCB cantilever beam structure 22.

However, the connection manner shown in FIG. 1 leads to the following problem: As the PCB cantilever beam structure 22 is lengthened (correspondingly, the through groove 210 is also lengthened), an assembly stress risk is reduced, but a signal return current (return current) path T is lengthened, thereby affecting quality of radio frequency signal transmission, which cannot meet a requirement of using a high frequency signal.

US2011157844A1 discloses a flat panel display module having anti-shock screw-tightening structure is provided. The flat panel display module includes a display panel, a flexible printed circuit, a printed circuit board, a back plate, a fastening element, and a flexible separator. The display panel has a signal connecting end. One end of the flexible printed circuit is electrically connected to the signal connecting end while the other end is electrically connected to the printed circuit board. The printed circuit board has a through hole. The back plate accommodates the display panel. The flexible printed circuit is disposed across the back plate so that the printed circuit board is parallel to the back plate. The fastening element which has a length greater than the thickness of the printed circuit board passes through the through hole and is secured to the surface of the back plate. The flexible separator is disposed between the back plate and the printed circuit board and pushes the printed circuit board away from the back plate so that the printed circuit board touches against the fastening element.

US2011075384A1 discloses that sensitive electronic components can be mounted on a printed circuit board within an electronic device. To isolate a sensitive component from stresses that may arise during an unintended impact event, the electronic component can be isolated using a groove in the printed circuit board. The electronic component may be mounted to a component mounting region using solder balls. The component mounting region may be surrounded on some or all sides by the groove. Flex circuit structures that bridge the groove or a portion of the rigid printed circuit board may be used to hold the component mounting region in place. The flex circuit structures may be provided in the form of separate structures or may be provided as an integral portion of the printed circuit board.

FR2698755A1 includes a printed circuit board which has a cut-out section which allows the section to move with respect to the printed circuit board plane. A screw in the cut-out section allows movement adjustment. The screw also connects to the refrigerator outer section. The power transistor is mechanically connected to the moving section, and electrically connected to the printed circuit. Its lower face lies on the refrigerator outer section which is made of a good conductor such as aluminum. Tightening the screw ensures good contact of the power transistor on the refrigerator ensuring good heat dissipation.

DE102007036939A1 discloses a unit has a carrier plate for electrical components, electronic components and/or mechanical components. The carrier plate is mechanically connected with housing at two fixing points. The carrier plate includes a bar for each of the two fixing points. The bar includes longitudinal ends lying oppositely in a longitudinal extension. The bar is limited between the longitudinal ends on both sides by exposed longitudinal edges. The bar includes bending sections, which run at an acute angle to a virtual linear connecting line of the fixing points.

### SUMMARY

An objective of embodiments of the present invention is to provide a signal connection apparatus, to shorten a signal return current path and improve quality of radio frequency signal transmission.

An embodiment of the present invention provides a signal connection apparatus, including:
a substrate, where the substrate has an upper surface and a lower surface that is opposite to the upper surface, and the substrate has a first groove that is opened on the upper surface, a first through groove that is opened on a bottom surface of the first groove and runs through the lower surface, and a second groove that is opened on the bottom surface of the first groove and is adjacent to an edge of the first through groove;
a conductive elastic piece, where the elastic piece includes a first end portion, a second end portion, and a bent portion that is connected between the first end portion and the second end portion, and the first end portion and the second end portion are coplanar and stick close to a bottom surface of the second groove by using a conductive adhesive;
a circuit board that is disposed on the substrate and abuts against the bent portion, where the substrate is opened with an annular hole, a part, extending in a protrusive manner to the annular hole, of the circuit board forms a cantilever beam, and the cantilever beam is opened with a second through groove; and
a screw, where the screw runs through the second through groove and the first through groove, and is in contact with the circuit board.

In a first possible implementation manner, the circuit board is a printed circuit board.

In a second possible implementation manner, the conductive elastic piece is made of, for example, tin-phosphor bronze.

In a third possible implementation manner, the cantilever beam includes a main portion and a connecting portion, the main portion is connected to a main portion of the circuit board by using the connecting portion, and the second through groove is opened on the main portion.

With reference to the third possible implementation manner, in a fourth possible implementation manner, the main portion of the cantilever beam is in the shape of a cylinder.

With reference to the third possible implementation manner, in a fifth possible implementation manner, the connecting portion is in the shape of a cuboid.

With reference to the third possible implementation manner, in a sixth possible implementation manner, an inner wall of the second through groove is opened with a female thread matching a male thread of the screw.

In a seventh possible implementation manner, the first groove is a square hole.

In an eighth possible implementation manner, the second groove is a square hole, and a width of the second groove matches a width of the elastic piece.

In a ninth possible implementation manner, the first through groove is a circular hole.

Compared with the prior art, according to the signal connection apparatus provided in the embodiments of the present invention, the conductive elastic piece is installed by opening a groove on a substrate, and a signal return current path is formed by using the elastic piece when the apparatus is working, thereby shortening a signal return current path existing in an existing radio frequency signal connection manner and achieving an objective of improving quality of signal transmission.

### BRIEF DESCRIPTION OF DRAWINGS

To describe the technical solutions in the embodiments of the present invention more clearly, the following briefly introduces the accompanying drawings required for describing the embodiments. Apparently, the accompanying drawings in the following description show merely some embodiments of the present invention, and persons of ordinary skill in the art may still derive other drawings from these accompanying drawings without creative efforts.
FIG. 1 is a schematic structural diagram of a radio frequency signal connection manner in the prior art;
FIG. 2 is a schematic structural diagram of installation of a signal connection apparatus according to an embodiment of the present invention;
FIG. 3 is a schematic structural diagram of a substrate of the signal connection apparatus shown in FIG. 2;
FIG. 4 is a schematic structural diagram of a conductive elastic piece of the signal connection apparatus shown in FIG. 2;
FIG. 5 is a schematic structural diagram showing that the conductive elastic piece shown in FIG. 4 is installed on the substrate shown in FIG. 3;
FIG. 6 is a schematic structural diagram of a circuit board of the signal connection apparatus shown in FIG. 2; and
FIG. 7 is a schematic diagram showing that a signal return current path of the signal connection apparatus shown in FIG. 2 is marked in an assembly drawing.

### DESCRIPTION OF EMBODIMENTS

The following clearly and completely describes the technical solutions in the embodiments of the present invention with reference to the accompanying drawings in the embodiments of the present invention. Apparently, the described embodiments are merely some but not all of the embodiments of the present invention.

Referring to FIG. 2, an embodiment of the present invention provides a signal connection apparatus 100, where the signal connection apparatus 100 includes a substrate 10, a conductive elastic piece 30, a circuit board 50, and a screw 70.

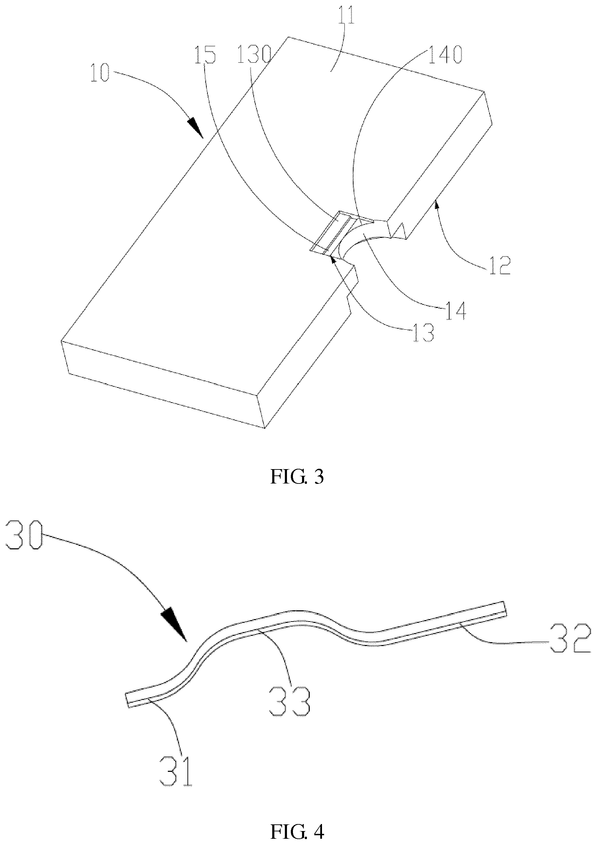

Further referring to FIG. 3, the substrate 10 is in the shape of a cuboid (but is not limited to the cuboid, for example, the substrate may be in the shape of a circular flake), and includes an upper surface 11, and a lower surface 12 that is opposite to the upper surface 11. In this embodiment, the substrate 10 has a first groove 13 that is opened on the upper surface 11. Specifically, the first groove 13 is a square hole, and the first groove 13 has a bottom surface 130.

The substrate 10 has a first through groove 14 that is opened on the bottom surface 130 of the first groove 13, and the first through groove 14 runs through the lower surface 12. In this embodiment, the first through groove 14 may be a circular hole (FIG. 3 shows only an arc segment of the circular hole, that is, an edge 140). In addition, in this embodiment, the substrate 10 has a second groove 15 that is opened on the bottom surface 130 of the first groove 13. In this embodiment, the second groove 15 is adjacent to the edge 140 of the first through groove 14, but does not run through the first through groove 14. In addition, the second groove 15 is also a square hole.

Further referring to FIG. 4, the elastic piece 30 includes a first end portion 31, a second end portion 32, and a bent portion 33. The first end portion 31 and the second end portion 32 are coplanar. The bent portion 33 is connected between the first end portion 31 and the second end portion 32, and the bent portion 33 protrudes out of a plane on which the first end portion 31 and the second end portion 32 are located. In this embodiment, the conductive elastic piece 30 is made of tin-phosphor bronze and has good conductivity. It may be understood that, in other modified implementation manners, the elastic piece 30 may also be made of other materials having good conductivity, which is not limited in a specific embodiment.

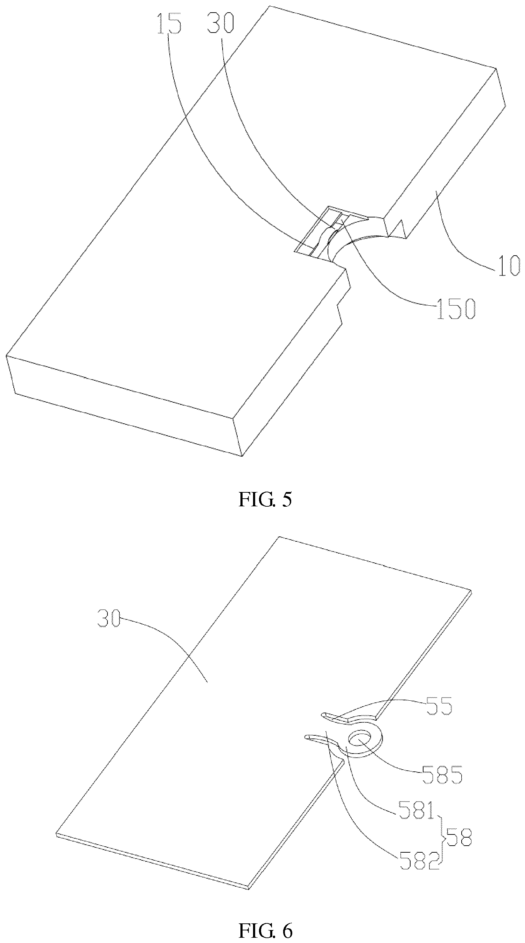

As shown in FIG. 5, the first end portion 31 and the second end portion 32 are coplanar and stick close to a bottom surface 150 of the second groove 15 by using a conductive adhesive, and a width of the second groove 15 matches a width of the elastic piece 30, so that the elastic piece 30 is stuck tightly in the second groove 15.

Referring to both FIG. 2 and FIG. 6, the circuit board 50 may be a rectangular plate, and is opened with an annular hole 55. In this embodiment, a part, extending in a protrusive manner to the annular hole 55, of the circuit board 50 forms a cantilever beam 58.

As shown in FIG. 6, the circuit board 50 matches the substrate 10, and the circuit board 50 is disposed on the substrate 10, and further abuts against the bent portion 33.

It may be understood that, in other modified implementation manners, the circuit board 50 and the substrate 10 may also be in other shapes, for example, in the shape of a cylinder, that is, shapes of the circuit board 50 and the substrate 10 may be set according to an actual use requirement, which is not limited in a specific embodiment.

In this embodiment, the cantilever beam 58 includes a main portion 581 and a connecting portion 582, the main portion 581 is roughly in the shape of a cylinder, the connecting portion 582 is roughly in the shape of a cuboid, and the main portion 581 is connected to a main portion of the circuit board 50 by using the connecting portion 582.

The main portion 581 of the cantilever beam 58 is opened with a second through groove 585. In this embodiment, the second through groove 585 may be a circular-hole through groove.

Still referring to FIG. 2, the screw 70 runs through the second through groove 585 and the first through groove 14. In this embodiment, a male thread of the screw 70 may be engaged with a female thread of the second through groove 585, so that the screw 70 is fastened to the circuit board 50, and is in contact with the circuit board 50.

According to the signal connection apparatus 100 provided in this embodiment of the present invention, the conductive elastic piece 30 is installed by opening a first groove 13 and a second groove 15 on a substrate 10, and a signal return current path T1 is formed by using the elastic piece 30 when the apparatus is working, thereby shortening a signal return current path existing in an existing signal connection apparatus, so that quality of signal transmission can be effectively improved.

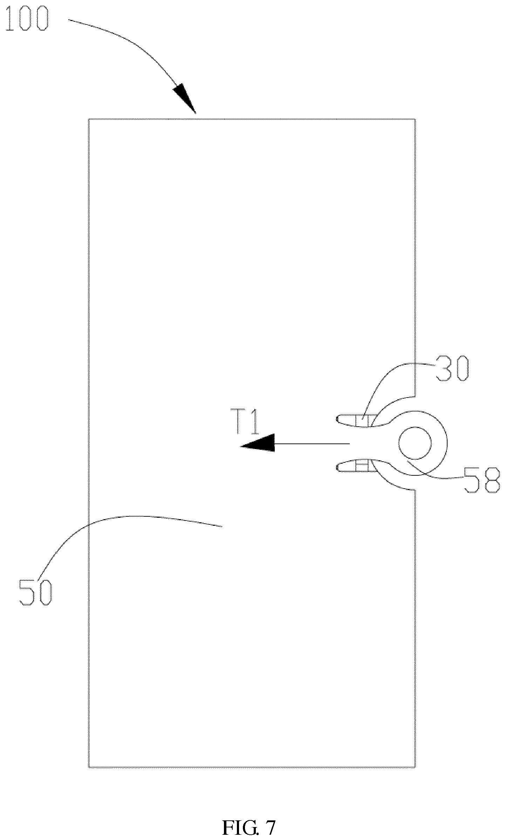

Referring to FIG. 7 and FIG. 1 for comparison, compared with a signal return current path T of a radio frequency signal connection manner provided in the prior art, a length of the signal return current path T1 of the signal connection apparatus 100 provided in this embodiment of the present invention is obvious shorter, and correspondingly, the quality of signal transmission is also obviously improved.

In addition, the elastic piece 30 has double properties of conductivity and elasticity, which can not only transmit a signal but also can be deformed mechanically in the second groove 15 of the PCB circuit board 50 to effectively reduce an assembly stress risk.

It may be understood that the second groove 15 is opened on the circuit board 50 to accommodate the elastic piece 30, so that it can be ensured that the elastic piece 30 is adjacent to the edge 140 of the first through groove 14, to ensure the quality of signal transmission.

Further, the elastic piece and the conductive adhesive are common materials in the industry that are easy to get and have low costs, and the whole signal connection apparatus 100 is conveniently to install in structure and is easy to operate, and is in a hard connection by using the screw, and is widely used in 3.5 G high frequency signal transmission.

## Claims

1. A signal connection apparatus (100), comprising:
a substrate (10), wherein the substrate (10) has an upper surface (11) and a lower surface (12) that is opposite to the upper surface (11), and the substrate (10) has a first groove (13) that is opened on the upper surface (11), a first through groove (14) that is opened on a bottom surface (130) of the first groove (13) and runs through the lower surface (12), and a second groove (15) that is opened on the bottom surface (130) of the first groove (13) and is adjacent to an edge of the first through groove (14);
a conductive elastic piece (30), wherein the elastic piece (30) comprises a first end portion (31), a second end portion (32), and a bent portion (33) that is connected between the first end portion (31) and the second end portion (32), and the first end portion (31) and the second end portion (32) are coplanar and stick close to a bottom surface (150) of the second groove (15) by using a conductive adhesive;
a circuit board (50) that is disposed on the substrate (10) and abuts against the bent portion (33), wherein the circuit board (50) is opened with an annular hole (55), a part, extending in a protrusive manner to the annular hole (55), of the circuit board (50) forms a cantilever beam (58), and the cantilever beam (58) is opened with a second through groove (585); and
a screw (70), wherein the screw (70) runs through the second through groove (585) and the first through groove (14), and is in contact with the circuit board (50).

2. The signal connection apparatus (100) according to claim 1, wherein the circuit board (50) is a printed circuit board.

3. The signal connection apparatus (100) according to claim 1 or 2, wherein the conductive elastic piece (30) is made of tin-phosphor bronze.

4. The signal connection apparatus (100) according to any one of claims 1-3, wherein the cantilever beam (58) comprises a main portion (581) and a connecting portion (582), the main portion (581) is connected to a main portion of the circuit board (50) by using the connecting portion (582), and the second through groove (585) is opened on the main portion (581).

5. The signal connection apparatus (100) according to claim 4, wherein the main portion (581) is in the shape of a cylinder.

6. The signal connection apparatus (100) according to claim 4 or 5, wherein the connecting portion (582) is in the shape of a cuboid.

7. The signal connection apparatus (100) according to any one of claims 4-6, wherein an inner wall of the second through groove (585) is opened with a female thread matching a male thread of the screw.

8. The signal connection apparatus (100) according to any one of claims 1-7, wherein the first groove (13) is a square hole.

9. The signal connection apparatus (100) according to any one of claims 1-8, wherein the second groove (15) is a square hole, and a width of the second groove (15) matches a width of the elastic piece (30).

10. The signal connection apparatus (100) according to any one of claims 1-9, wherein the first through groove (14) is a circular hole.

## Patentansprüche

1. Signal verbindungsvorrichtung (100), umfassend:
ein Substrat (10), wobei das Substrat (10) eine obere Fläche (11) und eine untere Fläche (12) hat, die der oberen Fläche (11) gegenüberliegt, und das Substrat (10) eine erste Nut (13), die auf der oberen Fläche (11) geöffnet ist, hat, eine erste durchgehende Nut (14), die auf einer unteren Fläche (130) der ersten Nut (13) geöffnet ist und durch die untere Fläche (12) durchgeht, und eine zweite Nut (15), die auf der unteren Fläche (130) der ersten Nut (13) geöffnet und zu einer Kante der ersten durchgehenden Nut (14) benachbart ist;
ein leitfähiges elastisches Teil (30), wobei das elastische Teil (30) einen ersten Endabschnitt (31), einen zweiten Endabschnitt (32) und einen gebogenen Abschnitt (33), der zwischen dem ersten Endabschnitt (31) und dem zweiten Endabschnitt (32) verbunden ist, umfasst, und der erste Endabschnitt (31) und der zweite Endabschnitt (32) koplanar sind und nahe einer unteren Fläche (150) der zweiten Nut (15) unter Verwenden eines leitfähigen Klebstoffs kleben;
eine Leiterplatte (50), die auf dem Substrat (10) angeordnet ist und gegen den gebogenen Abschnitt (33) anschlägt, wobei die Leiterplatte (50) mit einer ringförmigen Bohrung (55) geöffnet ist, ein Teil der Leiterplatte (50), der sich in einer vorragenden Art zu der ringförmigen Bohrung (55) erstreckt, einen auskragenden Träger (58) bildet, und der auskragende Träger (58) mit einer zweiten durchgehenden Nut (585) geöffnet ist, und
eine Schraube (70), wobei die Schraube (70) durch die zweite durchgehende Nut (585) und die erste durchgehende Nut (14) verläuft und mit der Leiterplatte (50) in Berührung ist.

2. Signalverbindungsvorrichtung (100) nach Anspruch 1, wobei die Leiterplatte (50) eine gedruckte Leiterplatte ist.

3. Signalverbindungsvorrichtung (100) nach Anspruch 1 oder 2, wobei das leitfähige elastische Teil (30) aus Zinn-Phosphor-Bronze gefertigt ist.

4. Signalverbindungsvorrichtung (100) nach einem der Ansprüche 1 bis 3, wobei der auskragende Träger (58) einen Hauptabschnitt (581) und einen Verbindungsabschnitt (582) umfasst, wobei der Hauptabschnitt (581) mit einem Hauptabschnitt der Leiterplatte (50) durch Verwenden des Verbindungsabschnitts (582) verbunden ist, und die zweite durchgehende Nut (585) auf dem Hauptabschnitt (581) geöffnet ist.

5. Signalverbindungsvorrichtung (100) nach Anspruch 4, wobei der Hauptabschnitt (581) die Form eines Zylinders hat.

6. Signalverbindungsvorrichtung (100) nach Anspruch 4 oder 5, wobei der Verbindungsabschnitt (582) die Form eines Würfels hat.

7. Signalverbindungsvorrichtung (100) nach einem der Ansprüche 4 bis 6, wobei eine Innenwand der zweiten durchgehenden Nut (585) mit einem Innengewinde, das zu einen Außengewinde der Schraube passt, geöffnet ist.

8. Signalverbindungsvorrichtung (100) nach einem der Ansprüche 1 bis 7, wobei die erste Nut (13) eine quadratische Bohrung ist.

9. Signalverbindungsvorrichtung (100) nach einem der Ansprüche bis 8, wobei die zweite Nut (15) eine quadratische Bohrung ist, und eine Breite der zweiten Nut (15) mit einer Breite des elastischen Teils (30) übereinstimmt.

10. Signalverbindungsvorrichtung (100) nach einem der Ansprüche 1 bis 9, wobei die erste durchgehende Nut (14) eine kreisförmige Bohrung ist.

## Revendications

1. Appareil de connexion du signal (100), comprenant :
un substrat (10), le substrat (10) ayant une surface supérieure (11) et une surface inférieure (12) qui est à l'opposé de la surface supérieure (11), et le substrat (10) ayant une première rainure (13) qui est ouverte sur la surface supérieure (11), une première rainure traversante (14) qui est ouverte sur une surface de fond (130) de la première rainure (13) et court à travers la surface inférieure (12), et une deuxième rainure (15) qui est ouverte sur la surface de fond (130) de la première rainure (13) et est adjacente à un bord de la première rainure traversante (14) ;
une pièce élastique conductrice (30), la pièce élastique (30) comprenant une première partie d'extrémité (31), une deuxième partie d'extrémité (32), et une partie courbée (33) qui est reliée entre la première partie d'extrémité (31) et la deuxième partie d'extrémité (32), et la première partie d'extrémité (31) et la deuxième partie d'extrémité (32) étant coplanaires et se collant près d'une surface de fond (150) de la deuxième rainure (15) au moyen d'un adhésif conducteur ;
une carte de circuit (50) qui est disposée sur le substrat (10) et bute contre la partie courbée (33), la carte de circuit (50) étant ouverte avec un trou annulaire (55), une partie s'étendant à la manière d'une saillie jusqu'au trou annulaire (55) de la carte de circuit (50) formant une pouture en porte-à-faux (58), et la poutre en porte-à-faux (58) étant ouverte avec une deuxième rainure traversante (585) ; et
une vis (70), la vis (70) courant à travers la deuxième rainure traversante (585) et la première rainure traversante (14), et étant en contact avec la carte de circuit (50).

2. Appareil de connexion du signal (100) selon la revendication 1, dans lequel la carte de circuit (50) est une carte de circuit imprimé.

3. Appareil de connexion du signal (100) selon la revendication 1 ou 2, dans lequel la pièce élastique conductrice (30) est constituée de bronze étain-phosphore.

4. Appareil de connexion du signal (100) selon l'une quelconque des revendications 1 à 3, dans lequel la poutre en porte-à-faux (58) comprend une partie principale (581) et une partie de connexion (582), la partie principale (581) est reliée à une partie principale de la carte de circuit (50) au moyen de la partie de connexion (582), et la deuxième rainure traversante (585) est ouverte sur la partie principale (581).

5. Appareil de connexion du signal (100) selon la revendication 4, dans lequel la partie principale (581) se présente sous la forme d'un cylindre.

6. Appareil de connexion du signal (100) selon la revendication 4 ou 5, dans lequel la partie de connexion (582) se présente sous la forme d'un cuboïde.

7. Appareil de connexion du signal (100) selon l'une quelconque des revendications 4 à 6, dans lequel une paroi interne de la deuxième rainure traversante (585) est ouverte avec un filet femelle correspondant à un filet mâle de la vis.

8. Appareil de connexion du signal (100) selon l'une quelconque des revendications 1 à 7, dans lequel la première rainure (13) est un trou carré.

9. Appareil de connexion du signal (100) selon l'une quelconque des revendications 1 à 8, dans lequel la deuxième rainure (15) est un trou carré, et une largeur de la deuxième rainure (15) correspond à une largeur de la pièce élastique (30).

10. Appareil de connexion du signal (100) selon l'une quelconque des revendications 1 à 9, dans lequel la première rainure traversante (14) est un trou circulaire.
